## Europäisches Patentamt

## European Patent Office

## Office européen des brevets

(11) Veröffentlichungsnummer: **0 063 274**
**B1**

(12) # EUROPÄISCHE PATENTSCHRIFT

(45) Veröffentlichungstag der Patentschrift:
18.07.84

(51) Int. Cl.³: **H 03 H 17/02**

(21) Anmeldenummer: **82102749.7**

(22) Anmeldetag: **31.03.82**

(54) **Wellendigitalfilter.**

(30) Priorität: **02.04.81 DE 3113371**

(43) Veröffentlichungstag der Anmeldung:
**27.10.82 Patentblatt 82/43**

(45) Bekanntmachung des Hinweises auf die Patenterteilung:
**18.07.84 Patentblatt 84/29**

(84) Benannte Vertragsstaaten:
**AT CH FR GB IT LI NL SE**

(56) Entgegenhaltungen:
**FR - A - 2 095 736**

**ARCHIV FÜR ELEKTRONIK UND
ÜBERTRAGUNGSTECHNIK, Band 25, Nr. 2, Februar
1971, Seiten 79-89, Stuttgart, DE. A. FETTWEIS: "Digital
filter structures related to classical filter networks"
IEEE TRANSACTIONS ON ACOUSTICS, SPEECH, AND
SIGNAL PROCESSING, Band ASSP-22, Nr. 4, August
1974, Seiten 231-235, New York, USA M.G. BELLANGER
et al.: "Interpolation, extrapolation, and reduction of
computation speed in digital filters"**

(73) Patentinhaber: **SIEMENS AKTIENGESELLSCHAFT,
Berlin und München Wittelsbacherplatz 2,
D-8000 München 2 (DE)**

(72) Erfinder: **Fettweis, Alfred, Prof., Dr., Im Königsbusch 30,
D-4630 Bochum (DE)**
Erfinder: **Nossek, Josef, Dr.-Ing., Waldstrasse 17,
D-8121 Iffeldorf (DE)**

0 063 274

## Beschreibung

Die Erfindung betrifft ein Wellendigitalfilter, das aus Addierern, Verzögerungsgliedern und Multiplizierern besteht.

In der Zeitschrift AEÜ, Band 25, 1974, Heft 2, Seiten 79 bis 89, sind digitale Filterstrukturen angegeben worden, die in bezug gesetzt sind zu klassischen Filternetzwerken. Für diese spezielle Gattung von digitalen Filtern hat sich zwischenzeitlich der Ausdruck Wellendigitalfilter eingebürgert. Auch diese Filter bestehen dem Grundkonzept nach aus Addierern, Verzögerungsgliedern und Multiplizierern, sie haben jedoch die Eigenschaft, daß sie unmittelbar den klassischen Filtern nachgebildet werden können. In Weiterentwicklung dieser Wellendigitalfilter ist in der Arbeit International Journal on Circuit Theory and Applications, Vol. 1, Seiten 5 bis 10 (1973), eine Schaltungsgattung beschrieben worden, für die es wesentlich ist, daß in solche Wellendigitalfilter sogenannte reflexionsfreie Tore eingeführt wurden. Im Unterschied zu üblichen Digitalfiltern, die nur eine einzige Eingangsklemme und eine einzige Ausgangsklemme haben, haben Wellendigitalfilter ein Eingangstor und ein Ausgangstor, von denen jedes eine Ausgangs- und eine Eingangsklemme hat. Es hat dies zur Folge, daß man solche Filter beispielsweise unmittelbar als Weichennetzwerke verwenden kann.

Bei der Anwendung solcher Filter, wie beispielsweise in Transmultiplexern, zeigt sich, daß auch hier ein in der üblichen Digitaltechnik ebenfalls bekanntes Problem, nämlich das der Abtastratenerhöhung bzw. das der Abtastratenerniedrigung auftritt. Bei Verwendung von Wellendigitalfiltern wurden bisher bei Abtastratenerhöhung »Nullen« eingefügt, eine Maßnahme also, die auch unter dem Ausdruck »zerofilling« bekannt ist, bzw. wurden bei der Abtastratenabsenkung Abtastwerte einfach weggelassen. Diese Maßnahmen sind deshalb nicht befriedigend, weil einerseits die Einführung von Nullen und andererseits das Weglassen von Abtastraten gegebenenfalls eine Qualitätsminderung für die zu verarbeitenden Signale zur Folge hat.

Der Erfindung liegt die Aufgabe zugrunde, Schaltungen anzugeben, mit denen sich die Abtastraten erhöhen bzw. erniedrigen lassen, ohne daß gleichzeitig der vorgenannte Nachteil in Kauf genommen werden muß.

Es werden für die einleitend genannte Filtergattung zwei Lösungsmöglichkeiten angegeben.

Eine erste Lösungsmöglichkeit besteht darin, daß zur Abtastratenerhöhung um den Faktor N das am Eingangstor zur Verfügung stehende reflektierte Signal zu denjenigen $N-1$ Taktzeitpunkten, zu denen die Quelle kein Signal liefert, direkt an eine für das Eingangssignal bestimmte Klemme geschaltet wird, derart, daß keine verzögerungsfreie Schleife gebildet wird.

Eine zweite Lösungsmöglichkeit besteht darin, daß zur Abtastratenabsenkung um den Faktor N das am Ausgangstor zur Verfügung stehende auslaufende Signal zu denjenigen $N-1$ Taktzeitimpulsen, zu denen an den Empfänger kein Signal geliefert wird, direkt an eine für das einlaufende Signal am Ausgangstor bestimmte Klemme geschaltet wird, derart, daß keine verzögerungsfreie Schleife gebildet wird.

In den Unteransprüchen sind weitere vorteilhafte Ausgestaltungen angegeben.

Anhand zweier Ausführungsbeispiele wird die Erfindung nachstehend noch näher erläutert. Es zeigt in der Zeichnung

Fig. 1 eine Anordnung zur Abtastratenerhöhung,

Fig. 2 das elektrische Ersatzschaltbild mit einem zugehörigen Referenz-Filter, ohne daß dabei der in Fig. 1 verwendete Schalter berücksichtigt ist,

Fig. 3 eine Anordnung zur Abtastratenerniedrigung,

Fig. 4 das elektrische Ersatzschaltbild zur Fig. 3 mit einem zugehörigen Referenzfilter, ohne daß dabei der in Fig. 3 verwendete Schalter berücksichtigt ist.

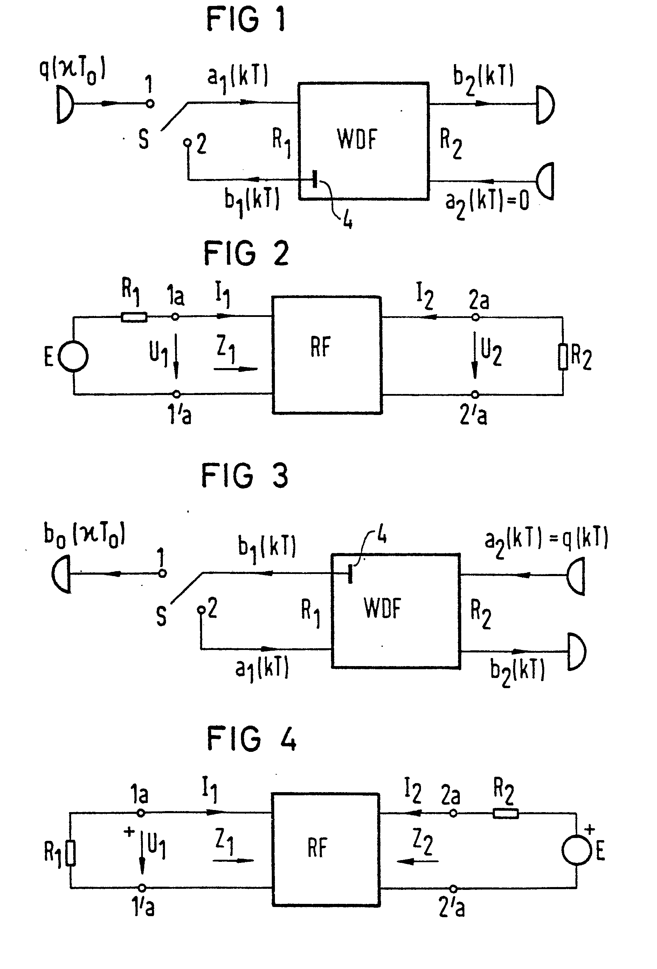

Allgemein sei darauf hingewiesen, daß sowohl in Fig. 1 als auch in Fig. 3 Wellendigitalfilter WDF verwendet sind, wie sie aus den einleitend genannten Literaturstellen bekannt sind. In Fig. 1 ist zu erkennen eine Signalquelle, die das Signal $q(\varkappa T_0)$ abgibt, es steht weiterhin zur Verfügung das Signal $a_1(kT)$, das in das Wellendigitalfilter WDF hineinfließt, und es steht zur Verfügung das Signal $b_1(kT)$, das aus dem Wellendigitalfilter WDF herausfließt. Entsprechend sind die Signale am Ausgang mit $b_2(t_0+kT)$ als herausfließendes Signal und mit $a_2(t_0 kT)$ als hineinfließendes Signal bezeichnet.

In der Schaltung nach Fig. 1 hat nun das Wellendigitalfilter WDF Tore mit den Torwiderständen $R_1$ bzw. $R_2$, die bei der Abtastrate $F=1/T$ arbeiten. Das Quellensignal ist nur für die niedrigere Rate $F_0=1/T_0$ vorhanden und man hat auf diese Weise die Beziehung $F_0=F/N$, $T_0=NT$, wobei N eine positive ganze Zahl ist. Es wird jetzt angenommen, daß k eine Folge von ganzen Zahlen ist, d. h. $k=\ldots -1,0,1,2,\ldots$ Zu jedem k läßt sich eine andere ganze Zahl $\varkappa$ definieren, so daß die Beziehung gilt: $0\le k-\varkappa N\le N-1$, $\varkappa=\ldots -1,0,1,2,\ldots$ Für ein gegebenes k ist somit der Wert von $\varkappa$ eindeutig, aber jedem $\varkappa$ entsprechen N bestimmte Werte von k. Mit dieser Feststellung können die einfallenden und auslaufenden Signale am Tor mit dem Torwiderstand $R_1$ als am Zeitpunkt kT auftretend angenommen werden. Die Quellensignale zu den Zeitpunkten $\varkappa T_0$ und die einfallenden $[a_2(t_0+kT)]$ und auslaufenden $[b_2(t_0+kT)]$ Signale am Tor mit dem Torwiderstand $R_2$ können am Zeitpunkt $t_0+kT$ als vorhanden betrachtet werden, wobei $t_0$ als eine Konstante zu betrachten ist. Diese Konstante kann als vollständig allgemein angenommen werden, da in einem Wellendigitalfilter die Signale an bestimmten Toren in Zeitmomenten auftreten, die gegeneinander verschoben sein können und die nicht mit einer Perioden-

2

dauer übereinstimmen müssen. Trotzdem wird man im allgemeinen davon ausgehen, daß $t_0 = 0$ ist, wie dies auch in den Fig. 1 und 3 dargestellt ist. Dementsprechend schreibt man für die verschiedenen Signale $a_1(kT)$, $b_1(kT)$, $q(\varkappa T_0)$ und $a_2(kT)$ und $b_2(kT)$. Der Schalter S in Fig. 1 stellt nun sicher, daß das auslaufende Signal $b_1$ in das Wellendigitalfilter WDF zurückgeführt wird, wenn kein Quellensignal ansteht. Demzufolge muß also der Schalter S in der Position 1 für $k = \varkappa N$ und in Position 2 für $k \neq \varkappa N$ sein. Zu beachten ist dabei, daß das Tor 1 ein sogenanntes reflexionsfreies Tor sein muß, wie dies in Fig. 1 (und in Fig. 3) durch den Querstrich 4 kenntlich gemacht ist, da andernfalls eine verzögerungsfreie Schleife entstehen würde. Solche reflexionsfreien Tore sind in der eingangs erwähnten Literaturstelle »International Journal on Circuit Theory and Applications«, Vol. 1, Seiten 5 bis 10, 1973, beschrieben.

Im Ersatzschaltbild von Fig. 2 ist nun eine Signalquelle E zu erkennen, der im Längszweig ihr Innenwiderstand $R_1$ folgt. Zwischen den Eingangsklemmen 1a und 1'a tritt die Spannung $U_1$ auf. In das Referenzfilter RF fließt der Strom $I_1$, die Eingangsimpedanz ist mit $Z_1$ bezeichnet. Am Eingang der Schaltung sind zu erkennen die Klemmen 2a und 2'a, zwischen denen die Spannung $U_2$ liegt. Es fließt der Strom $I_2$ in das Referenzfilter RF, der Abschlußwiderstand ist mit $R_2$ bezeichnet. Für diese Schaltung läßt sich eine diskrete Pulsimpedanz entsprechend $\check{Z}_1$ nach Gleichung (1) definieren:

$$\check{Z} = \sum_{n=0}^{N-1} \check{Z}_1 \left( p + jn\,\Omega_0 \right). \qquad (1)$$

Hierin bedeuten $\check{Z}_1(p) = Z_1[\tanh(pT/2)]$ und n ist eine Zählvariable, die zwischen 0 und $N-1$ läuft, $\Omega_0 = 2\pi\,F_0 = 2\pi/T_0$ wurde indirekt einleitend bereits gegeben, und es bedeutet noch p die komplexe Frequenzvariable.

Unter den vorstehend gemachten Voraussetzungen läßt sich also folgende Konversionsfunktion $H_{21n}$ für das Filter gemäß Fig. 1 und Fig. 2 definieren:

$$H_{21n} = \frac{2\sqrt{NR_1 R_2} \cdot \hat{M}_{21}\,(p + jn\,\Omega_0)}{\check{Z}_1 + NR_1} \quad \text{für } n = 0 \text{ bis } N-1. \qquad (2)$$

Dabei ist

$$\hat{M}_{21}\,(p + jn\,\Omega_0) = M_2 \left[ \tanh \frac{(p + jn\,\Omega_0)\,T}{2} \right]$$

die Stromübertragungsfunktion $-I_2/I_1$.

Vorstehend ist also noch zu beachten, daß der Ausdruck »Konversionsfunktion« bewußt verwendet wird, um gegenüber dem Ausdruck »Transferfunktion« zu unterscheiden, weil tatsächlich auch eine Frequenzkonversion auftritt. Für $n = 0$ haben Eingangs- und Ausgangssignal gleiche Frequenz, es handelt sich also bei $H_{210} = H_{21}$ um eine Transferfunktion.

In den Fig. 1 und 2 läßt sich noch erreichen, daß das am Eingangstor $R_1$ zur Verfügung stehende reflektierte Signal $b_1(kT)$ invertiert an die für das Eingangssignal $a_1(kT)$ bestimmte Klemme geschaltet werden kann. Hierfür gilt dann die Beziehung

$$a_1(kT) = -b_1(kT) \quad \text{für } k \neq \varkappa N. \qquad (3)$$

Für diesen Betriebsfall läßt sich eine entsprechende Transfer- bzw. Konversionsfunktion analog zu (2) herleiten.

In Fig. 3 ist nun eine Möglichkeit zur Abtastratenabsenkung um den Faktor N unter Verwendung des Schalters S am Ausgang des Filters WDF gezeigt. Der Schalter S schaltet dabei am Ausgangstor $R_1$ in einer solchen Weise, daß das dort auftretende auslaufende Signal $b_1$ zu denjenigen $N-1$ Taktzeitpunkten, zu denen an den Empfänger $b_0(\varkappa T_0)$ kein Signal geliefert wird, direkt an die für das einlaufende Signal $a_1(kT)$ bestimmte Klemme geliefert wird. Es gelten dabei auch im wesentlichen die vorstehenden Ausführungen in analoger bzw. entsprechender Weise, und es sind wirkungsgleiche Elemente mit den gleichen Bezugsziffern bezeichnet. Im Unterschied zu Fig. 1 sind aber in Fig. 3 ein- und auslaufende Signalgrößen gegeneinander vertauscht, weshalb in Fig. 4 die Ersatzquelle E am Klemmenpaar 2a, 2a' des Filters erscheint und in Fig. 3 ein Empfänger das Signal $b_0(\varkappa T_0)$ empfängt. Es läßt sich hierfür zeigen, daß die Transferfunktion folgendermaßen darstellbar ist:

$$H_{12n} = H_{12}\,(\psi) = \frac{2\sqrt{NR_1 R_2} \cdot M_{12}\,(\psi)}{\check{Z}_1 + NR_1}. \qquad (4)$$

Hierbei bedeutet noch

3

$$M_{12}(\psi) = M_{12}\left[\tanh\frac{pT}{2}\right] = \hat{M}_{16}(p) = -I_1/I_2$$

die Stromübertragungsfunktion. Für ein reziprokes Referenzfilter gilt übrigens $M_{21} = M_{12}$.

Auch bei der Schaltung nach Fig. 3 läßt sich gemäß Gleichung (3) erreichen, daß das am Ausgangstor $R_1$ zur Verfügung stehende auslaufende Signal $b_1(kT)$ invertiert an die für das einlaufende Signal $a_1(kT)$ bestimmte Klemme über den Schalter S geschaltet wird. Wiederum kann dafür eine zu (4) analoge Transferfunktion angegeben werden.

Die vorstehend beschriebene Realisierung benutzt also die am Ein- bzw. Ausgang eines Wellendigitalfilters WDF zur Verfügung stehenden reflektierten Signale und koppelt sie zwischen den Abtastzeitpunkten an den Ein- bzw. Ausgang des Filters wieder ein. Dadurch läßt sich ein Dynamikgewinn von $10 \log N$ als Abtastratenerhöhung bzw. -absenkung erzielen. Die erreichbare Sperrdämpfung wird bei gleichen Durchlaßeigenschaften und gleichem Filtergrad ebenfalls höher.

## Patentansprüche

1. Wellendigitalfilter, das aus Addierern, Verzögerungsgliedern und Multiplizierern besteht, dadurch gekennzeichnet, daß zur Abtastratenerhöhung um den Faktor N das am Eingangstor $(R_1)$ zur Verfügung stehende reflektierte Signal $(b_1)$ zu denjenigen $N-1$ Taktzeitpunkten, zu denen die Quelle kein Signal $(q)$ liefert, direkt an eine für das Eingangssignal $(a_1)$ bestimmte Klemme geschaltet wird, derart, daß keine verzögerungsfreie Schleife gebildet wird (Fig. 1, Fig. 2).

2. Wellendigitalfilter nach Anspruch 1, dadurch gekennzeichnet, daß das am Eingangstor $(R_1)$ zur Verfügung stehende reflektierte Signal $(b_1)$ invertiert an die für das Eingangssignal $(a_1)$ bestimmte Klemme geschaltet wird.

3. Wellendigitalfilter, das aus Addierern, Verzögerungsgliedern und Multiplizierern besteht, dadurch gekennzeichnet, daß zur Abtastratenabsenkung um den Faktor N das am Ausgangstor $(R_1)$ zur Verfügung stehende auslaufende Signal $(b_1)$ zu denjenigen $N-1$ Taktzeitpunkten, zu denen an den Empfänger $(b_0)$ kein Signal geliefert wird, direkt an eine für das einlaufende Signal $(a_1)$ am Ausgangstor $(R_1)$ bestimmte Klemme geschaltet wird, derart, daß keine verzögerungsfreie Schleife gebildet wird (Fig. 3, Fig. 4).

4. Wellendigitalfilter nach Anspruch 3, dadurch gekennzeichnet, daß das am Ausgangstor $(R_1)$ zur Verfügung stehende auslaufende Signal $(b_1)$ invertiert an die für das einlaufende Signal $(a_1)$ bestimmte Klemme geschaltet wird.

## Claims

1. A digital wave filter formed with adders, delay elements and multipliers, characterised in that the sampling rate is increased by the factor N by directly connecting the reflected signal $(b_1)$ available at the input gate $(R_1)$, to a terminal provided for the input signal $(a_1)$ at those $N-1$ clock pulse times at which the source does not supply a signal $(q)$, in such a manner that no delay-free loop is formed (Fig. 1, Fig. 2).

2. A digital wave filter as claimed in Claim 1, characterised in that the reflected signal $(b_1)$ available at the input gate $(R_1)$ is connected to the terminal provided for the input signal $(a_1)$ in an inverted fashion.

3. A digital wave filter formed with adders, delay elements and multipliers, characterised in that the sampling rate is reduced by the factor N by directly connecting the outgoing signal $(b_1)$ available at hte output gate $(R_1)$, to a terminal provided for the incoming signal $(a_1)$ at the output gate $(R_1)$ at those $N-1$ clock pulse times, at which no signal is fed to the receiver $(b_0)$, in such a manner that no delay-free loop is formed (Fig. 3, Fig. 4).

4. A digital wave filter as claimed in Claim 3, characterised in that the outgoing signal $(b_1)$ available at the output gate $(R_1)$ is connected to the terminal provided for the incoming signal $(a_1)$ in an inverted fashion.

## Revendications

1. Filtre numérique d'ondes qui est constitué par des additionneurs, des éléments de retard et des multiplicateurs, caractérisé par le fait que pour augmenter la fréquence d'échantillonnage du facteur N, le signal réfléchi $(b_1)$ disponible au niveau de la porte d'entrée $(R_1)$ est appliqué directement, aux $N-1$ instants de cadence auxquels la source ne délivre aucun signal $(q)$, sur une borne destinée au signal d'entrée $(a_1)$ de manière qu'aucune boucle sans retard ne soit formée (figure 1, figure 2).

2. Filtre numérique d'ondes suivant la revendication 1, caractérisé par le fait que le signal réfléchi $(b_1)$ disponible au niveau de la porte d'entrée $(R_1)$ est appliqué sous forme inversée à la borne destinée au signal d'entrée ($a_1$).

3. Filtre numérique d'ondes qui est constitué par des additionneurs, des éléments de retard et des multiplicateurs, caractérisé par le fait que pour réduire la fréquence d'échantillonnage du facteur N, le signal de sortie disponible au niveau de la porte de sortie est appliqué directement, aux N−1 instants de cadence auxquels aucun signal n'est délivré au récepteur, à une borne destinée au signal qui arrive au niveau de la porte de sortie, de manière qu'aucune boucle sans retard ne soit formée (figure 3, figure 4).

4. Filtre numérique d'ondes suivant la revendication 3, caractérisé par le fait que le signal qui sort ($b_1$) disponible au niveau de la porte de sortie ($R_1$) est appliqué sous forme inversée à la borne destinée au signal qui arrive ($a_1$).

# FIG 1

$q(\varkappa T_0)$

$a_1(kT)$

$b_2(kT)$

1

S

2

$R_1$

WDF

$R_2$

$b_1(kT)$

4

$a_2(kT) = 0$

# FIG 2

$R_1$   1a   $I_1$

$I_2$   2a

E

$U_1$   $Z_1$

RF

$U_2$

$R_2$

1'a

2'a

# FIG 3

$b_0(\varkappa T_0)$

$b_1(kT)$

4

$a_2(kT) = q(kT)$

1

S

2

$R_1$

WDF

$R_2$

$a_1(kT)$

$b_2(kT)$

# FIG 4

1a   $I_1$

$I_2$   2a   $R_2$

$R_1$

$U_1$   $Z_1$

RF

$Z_2$

E

1'a

2'a